# EUROPEAN PATENT APPLICATION

(11) **EP 3 321 240 A1**
(43) Date of publication of application: **16.05.2018**
(21) Application number: 17201154.6
(22) Date of filing: 10.11.2017
(51) Int. Cl.: C03C 23/00, C03B 29/02, G03F 1/60

(54) **SURFACE FINISHING FOR GLASS COMPONENTS USING A LASER**

(30) Priority: 10.11.2016 US 201615348665
(71) Applicant: Goodrich Corporation, Charlotte, NC 28217-4578 (US)
(72) Inventor: SOUTHARD, Bari M., Bridgewater, CT Connecticut 06752 (US); EAST, Matthew J., Danbury, CT Connecticut 06811 (US); DUNN, Daniel E., Bethel, CT Connecticut 06801 (US); HARRISON, Kramer, Norwalk, 06854 (US)
(74) Representative: Hughes, Andrea Michelle

(57) **Abstract**

A method includes applying a laser (101) directly to a surface of a glass substrate (105) to smooth the surface of the glass substrate. The method can further include applying a reflective coating (107) directly to the smoothed surface of the glass substrate. An apparatus can include a titania-silica glass substrate having a laser polished surface that is not a separate layer from the glass substrate. The apparatus can include a reflective surface applied directly to the laser polished surface.

## Description

### BACKGROUND

### 1. Field

The present disclosure relates to surface finishing of structures, more specifically to surface finishing of glass components (e.g., titania-silica glass).

### 2. Description of Related Art

Surface finish of low expansion titania-silica glass structures can affect strength and cleanability of the structure. Rough, non-specular surfaces are produced by machining, grinding, lapping, and acid-etching processes which form the structure. Polishing has traditionally been mechanically and/or chemically accomplished which involves high cost and time requirements associated with glass polishing.

Such conventional methods and systems have generally been considered satisfactory for their intended purpose. However, there is still a need in the art for surface finishing for glass components. The present disclosure provides a solution for this need.

### SUMMARY

A method includes applying a laser directly to a surface of a glass substrate to smooth the surface of the glass substrate. The method can further include applying a reflective coating directly to the smoothed surface of the glass substrate.

In certain embodiments, the method may include optical figuring the glass substrate between applying the laser (smoothing) and applying a reflective coating to ensure the dimensional accuracy of the smoothed surface before coating it. Optical figuring may be chemical, mechanical, or by any other suitable means.

The glass substrate can be formed from ultra-low expansion glass. The ultra-low expansion glass can be titania-silica glass, for example.

The glass substrate can be a single piece. In certain embodiments, the glass substrate is shaped to be an optical component substrate. For example, the glass substrate can be shaped to be a mirror substrate.

Applying a laser can include doing so without altering the optical shape or characteristics of the glass substrate. In certain embodiments, applying a laser can include melting a surface of the glass substrate. Applying a laser can include pulsing the laser. In certain embodiments, applying a laser can include altering frequency of the laser pulsing. Applying a laser can include ablating and/or vaporizing imperfections or contaminants in the surface. The method can include filling in indentations in the surface. In certain embodiments, applying the laser can include removing bubbles from the surface.

In accordance with at least one aspect of this disclosure, an apparatus can include a titania-silica glass substrate having a laser polished surface that is not a separate layer from the glass substrate. The apparatus can include a reflective surface applied directly to the laser polished surface. The laser polished surface can be optically figured before the reflective surface is applied.

The glass substrate can be a single piece. The glass substrate can be shaped to be an optical component substrate. For example, the glass substrate can be shaped to be a mirror substrate.

These and other features of the systems and methods of the subject disclosure will become more readily apparent to those skilled in the art from the following detailed description taken in conjunction with the drawings.

### BRIEF DESCRIPTION OF THE DRAWINGS

So that those skilled in the art to which the subject disclosure appertains will readily understand how to make and use the devices and methods of the subject disclosure without undue experimentation, embodiments thereof will be described in detail herein below with reference to certain figures, wherein:
Fig. 1 is a diagrammatic side view of an embodiment of a method in accordance with this disclosure, showing a laser being applied directly to a surface of a glass substrate;
Fig. 2 is a zoomed view of the surface of the surface of the embodiment of Fig. 1, showing the laser smoothing the rough surface; and
Fig. 3 is a side view of the substrate of Fig. 1 after smoothing and having a reflective coating applied thereto.

### DETAILED DESCRIPTION

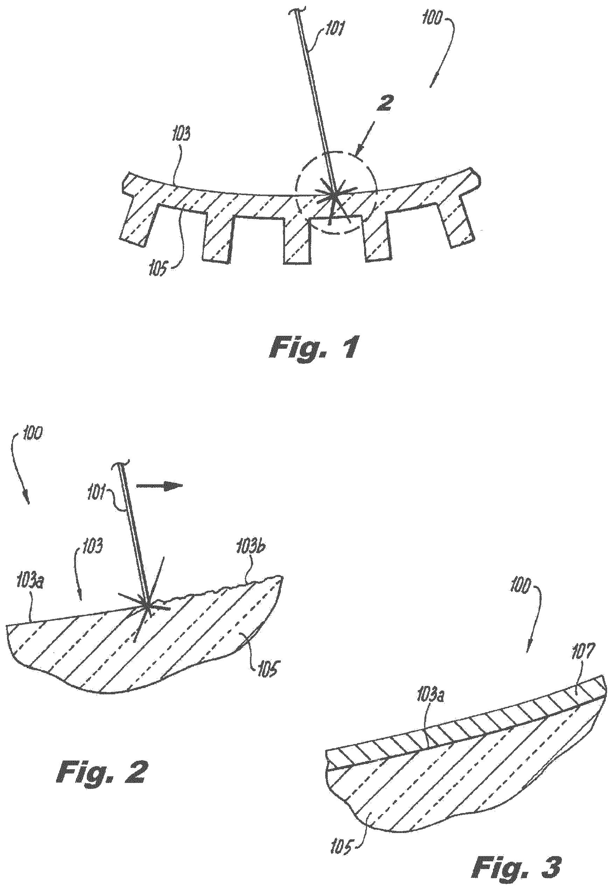

Reference will now be made to the drawings wherein like reference numerals identify similar structural features or aspects of the subject disclosure. For purposes of explanation and illustration, and not limitation, an illustrative view of an embodiment of a method in accordance with the disclosure is shown in Fig. 1 and is designated generally by reference character 100. Other embodiments and/or aspects of this disclosure are shown in Figs. 2 and 3. The systems and methods described herein can be used to smooth a glass substrate, for example.

Referring to Figs. 1 and 2, a method includes applying a laser 101 directly to a surface 103 of a glass substrate 105 to smooth the surface 103 of the glass substrate 105. The laser power, frequency, pulsing, and/or any other suitable characteristics can be selected to rapidly heat the surface 103 of the glass substrate 105 to ablate, melt, and/or vaporize the surface 103 to smooth the surface 103. For example, as shown in Fig. 2, the laser 101 can be moved along the surface 103 such that it forms a smooth surface 103a from the rough surface 103b.

The glass substrate 105 can be formed from ultra-low expansion glass. The ultra-low expansion glass can be titania-silica glass, for example. In this regard, the laser characteristics can be selected to be optimized for heating the surface 103 of titania-silica glass.

The glass substrate 105 can be a single piece in certain embodiments. In certain embodiments, the glass substrate 105 can be shaped to be an optical component substrate. For example, the glass substrate 105 can be shaped to be a mirror substrate (e.g., such that it includes a lightweight design). Any other suitable shape is contemplated herein.

In certain embodiments, the method may include optical figuring the glass substrate 105 between applying the laser (smoothing) and applying a reflective coating to ensure the dimensional accuracy of the smoothed surface before coating it. Optical figuring may be chemical, mechanical, or by any other suitable means.

Applying a laser can include doing so without altering the optical shape or characteristics of the glass substrate. In certain embodiments, applying a laser can include melting a surface of the glass substrate. Applying a laser can include pulsing the laser. In certain embodiments, applying a laser can include altering frequency of the laser pulsing. Applying a laser can include ablating and/or vaporizing imperfections or contaminants in the surface. The method can include filling in indentations in the surface. In certain embodiments, applying the laser can include removing bubbles from the surface.

Referring to Fig. 3, the method can further include applying a reflective coating 107 directly to the smoothed surface 103a (whether optically figured or not) of the glass substrate 105. The reflective coating 107 can be any suitable specular layer, for example.

In accordance with at least one aspect of this disclosure, embodiments of a method as described above can create an apparatus 100 that can include a glass substrate (e.g., made of titania-silica) having a laser polished surface 103a that is not a separate layer from the glass substrate 105. As shown in Fig. 3, the apparatus 100 can include a reflective surface applied directly to the laser polished surface. The substrate 105 can be as described above, for example.

As described above, embodiments treat the surface of a low expansion titania-silica glass structure with laser irradiation. The surface finish is altered, removing roughness and subsurface damage, while generating a smooth, specular surface with high characteristic strength. Laser surface treatment offers a fast alternative to acid etching and polishing, and is also free of hazardous chemicals. The treatment can readily target surfaces of the glass (substrate or part) which are known to bear large loads or experience high stress concentrations, improving the strength of the glass in a targeted approach, only where necessary for example (for glass parts, the strength of the part is often determined by the characteristic flaw size or the largest flaw left behind after the final surface finish).

The smoother, specular surface produced with the laser irradiation is stronger due to the reduction of sharp surface flaws. For the same reason these surfaces are easier to clean and keep clean, which can be important for titania-silica glass components used in precision equipment, optical systems, space systems and equipment used in clean rooms, such as microlithography equipment.

Embodiments can be used in structures requiring high strength and reliability while also requiring low coefficient of thermal expansion (CTE) and/or the ability to clean well, such as coated optics, microlithography, metering structures, medical systems, and high precision metrology instruments. Also, embodiments can allow for more economical edge finishing for applications already using silica-titania glass, such as microlithography, precision optics, space-borne optics for example.

The methods and systems of the present disclosure, as described above and shown in the drawings, provide for methods and systems with superior properties including strength and cleanability for example. While the apparatus and methods of the subject disclosure have been shown and described with reference to embodiments, those skilled in the art will readily appreciate that changes and/or modifications may be made thereto without departing from the scope of the invention as defined by the claims.

## Claims

1. A method, comprising:
applying a laser (101) directly to a surface of a glass substrate (105) to smooth the surface of the glass substrate.

2. The method of claim 1, further comprising applying a reflective coating (107) directly to the smoothed surface of the glass substrate.

3. The method of claim 2, further comprising optically figuring the glass substrate after applying the laser but before applying a reflective coating to ensure the dimensional accuracy of the smoothed surface before coating it.

4. The method of claim 1, 2 or 3, wherein the glass substrate is formed from ultra-low expansion glass.

5. The method of any preceding claim, wherein the glass substrate is a single piece.

6. The method of claim 5, wherein the glass substrate is shaped to be an optical component substrate, for example a mirror substrate.

7. The method of any preceding claim, wherein applying a laser includes doing so without altering the optical shape or characteristics of the glass substrate, or wherein applying a laser includes melting a surface of the glass substrate, or wherein applying a laser includes ablating and/or vaporizing imperfections or contaminants in the surface, or wherein applying a laser includes removing bubbles from the surface.

8. The method of any preceding claim, wherein the method includes filling in indentations in the surface.

9. The method of any preceding claim, wherein applying a laser includes pulsing the laser.

10. The method of claim 9, wherein applying a laser includes altering frequency of the laser pulsing.

11. An apparatus, comprising:
a titania-silica glass substrate (105) having a laser polished surface (103a) that is not a separate layer from the glass substrate.

12. The apparatus of claim 11, further comprising a reflective surface (107) applied directly to the laser polished surface.

13. The apparatus of claim 12, wherein the glass substrate is a single piece.

14. The apparatus of claim 13, wherein the glass substrate is shaped to be an optical component substrate.

15. The apparatus of claim 14, wherein the glass substrate is shaped to be a mirror substrate.
